# EUROPEAN PATENT APPLICATION

(11) **EP 3 650 260 A1**
(43) Date of publication of application: **13.05.2020**
(21) Application number: 19201873.7
(22) Date of filing: 08.10.2019
(51) Int. Cl.: B60L 3/00, G01R 31/08, G01R 31/12, H02H 1/00, B60M 1/28

(54) **A DIAGNOSIS NETWORK OF A PLURALITY OF ELECTRIFIED LINES AND/OR OF SLIDING CONTACTS OF A PLURALITY OF ELECTRIC TRACTION VEHICLES AND CORRESPONDING METHOD**

(30) Priority: 10.10.2018 IT 201800009325
(71) Applicant: Umpi S.r.l., 47841 Cattolica (Rimini) (IT)
(72) Inventor: CONTINI, Claudio, 00144 ROMA (IT)
(74) Representative: Puggioli, Tommaso

(57) **Abstract**

Described is a diagnosis network of electrified lines and/or sliding contacts of electric traction vehicles (1), comprising a device (3) for detecting electric arcs which occur between a sliding contact (10) of an electric traction vehicle (1) and a respective electrified line (20), comprising: at least one radiofrequency receiving circuit (30), configured to receive a first radiofrequency signal (IN1), positioned close to an electrical contact portion (4) between the sliding contact (10) of the electric traction vehicle (1) and the respective electrified line (20), a processor (32), configured to receive the first radiofrequency signal (IN1), verify the presence of at least one electric arc as a function of the first radiofrequency signal (IN1), generate an output signal (OUT) if the presence of an electric arc is verified, transmit the output signal (OUT); the output signal (OUT) comprises a first component indicating the detection of the electric arc between the sliding contact (10) of the electric traction vehicle (1) and the respective electrified line (20).

The network also comprises a remote processor (5; 5'), configured to receive a plurality of output signals (OUT) from at least one device in said plurality of devices, the output signals (OUT) indicating the detection of electric arcs which occur at said contact portions (4), and verify, as a function of said plurality of output signals (OUT), a presence of one or more critical conditions at least at one electrified line (20) in said plurality of electrified lines (20) and/or at least at a sliding contact (10) of an electric traction vehicle (1) in said plurality of electric traction vehicles (1).

## Description

The present invention relates to a diagnosis network of electrified lines and/or sliding contacts of electric vehicles, which uses a radio receiver for the detection of electric arcs which occur between an electric traction vehicle and a relative power supply line, for example in the case of trains (in particular, High Speed Trains), metros, trams, trolleybuses, etc. The invention also relates to a corresponding diagnosis network comprising a plurality of detection devices according to the invention and a corresponding method.

For the sake of brevity and ease of understanding, specific reference will be made below to the trains of the TAV type without, however, limiting the scope of the invention.

High speed trains (for example, speeds in the order of 300 km/h) comprise electric traction vehicles travelling on dedicated lines and they draw their energy from power supply lines or electrified lines. The power supply lines may comprise one or more aerial contact lines (catenaries) which are kept suspended by supporting poles.

Conventionally, the trains connect to these power supply lines by means of sliding contacts comprising pantographs, that is to say, one or more foldable metal arms, positioned on the upper roof of the train, configured for coupling with the aerial contact lines of the power supply line for powering the vehicle. The pantographs therefore allow an electrical coupling between the train, for example an electric motor unit of the train and the respective power supply line.

In the case of a train, an effective and continuous electrical coupling between the sliding contact and the aerial contact lines is desirable since it allows a correct operation of the drive unit of the train. Interruption of the coupling between the sliding contact and the aerial contact line (even relatively short) may lead to a degradation of the aerial contact line, the sliding contact and/or electrical parts in the motor unit. Moreover, these interruptions may result in a generation of electromagnetic disturbances which can create problems to electronic apparatuses in the vicinity.

The contact interruptions may be due to numerous reasons. For example, there may be contact discontinuities due to natural phenomena or failure of the ballast on which the tracks are positioned which determine an increase in the distance between the sliding contact and the relative aerial contact line with consequent reduction in the contact force. In other cases, there may be a slight yield of the cable which keeps under tension the aerial contact line which can oscillate during the transit of the train. Moreover, the speed of the train may result in interruptions, for example due to the vibrations of the train during the movement.

In the case of interruptions between the sliding contact and the aerial contact line, the distance and the considerable voltage differences between them can lead to the creation of electric arcs, that is, electrical discharges in air between the two metal contacts having a considerable difference in potential. Electric arcs may cause a deterioration of the aerial contact line and/or the sliding contact. For example, electric arcs can produce various types of wear, caused mainly by the oxidisation, the detachment of parts and/or the heat developed during discharge. Moreover, the electric arcs may have an effect on the motor unit of the train for example accelerating the aging and the wear due to the presence of various voltage and current harmonics.

Solutions are known which are able to perform a diagnosis of the railway network; in Italy, for example, there are DIA.MAN.TE trains. These trains allow diagnostics of any critical aspects of the network including any electric arcs present between the pantograph of the train and the respective aerial contact line. However, a diagnosis using these type of trains has one or more drawbacks, for example the diagnostic of a particular railway line is linked to the passage of the trains on it. The diagnostic may therefore be sporadic and localised to the portion of the network on which the train has passed.

Moreover, prior art systems for measuring electric arcs may comprise video cameras, for example the *Electric Arcs Detection System* (EADS). The video cameras may be positioned substantially at the sliding contact of the train and the aerial contact line, for detecting the formation of electric arcs capturing images of the phenomenon. However, this technology requires frequent maintenance, for example for cleaning the optical part due to dust and/or dirt which accumulates. Moreover, the video cameras, often equipped with anti-condensation heaters, may require a coupling to the motor unit of the train since they consume a large quantity of energy. This coupling may be problematic, for example it may not be authorised due to safety problems for skilled personnel.

In this context, the main technical purpose of the invention is to propose a detection device and method as well as a diagnostic network which are free of the above-mentioned drawbacks.

An aim of the invention is to provide a portable and/or easy to install device, so that it is possible to install the device on any type of train. In this way, it is possible to provide a widespread and frequent monitoring of a network, for example railway network, since the presence of one or more devices on trains which travel along the railway network makes it possible to signal almost in real time any critical aspects on it.

An aim of the invention is to provide a device for detecting electric arcs which is free of maintenance or cleaning/which requires reduced maintenance or cleaning.

Moreover, an aim of the invention is to provide a device with a low cost, for example both in terms of production and maintenance.

A further aim of the invention is to provide a device designed for high speed trains which has a relatively low time for detecting electric arcs.

The technical purpose indicated and the aims specified are substantially achieved by a detection device according to claim 1, a diagnosis network according to claim 8 and a corresponding method according to claim 11.

Further features and advantages of the invention are more apparent in the non-limiting description which follows of one or more embodiments as illustrated in the accompanying drawings, in which:
- Figure 1 illustrates an example, partly in blocks, of a railway line in which the device according to the invention is positioned,
- Figure 2 illustrates an example block diagram of a device according to one or more embodiments,
- Figure 3 illustrates an example block diagram of a device according to one or more embodiments, and
- Figure 4 illustrates a non-limiting example of a diagnosis network according to one or more embodiments.

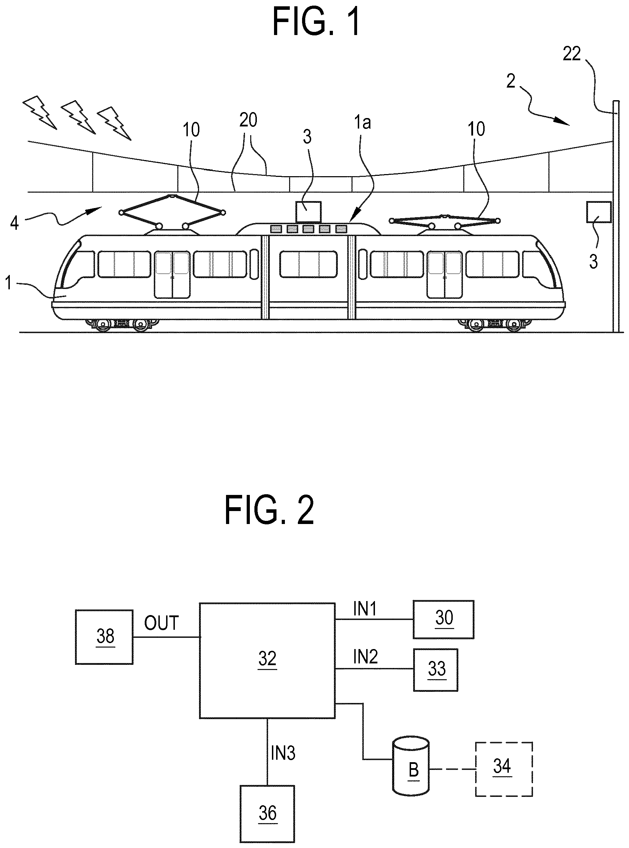

With reference to Figure 1, the numeral 1 denotes an electric traction vehicle. For simplicity, Figure 1 shows an electric traction train 1, comprising an electric motor unit (not shown in the drawing) and one or more sliding contacts 10, for example pantographs, mounted on a roof 1 a of the train 1.

The sliding contacts 10 are configured to supply energy to the motor unit. In order to do this, the sliding contacts 10 can be coupled, by means of contact portions 4, to a source of electricity, for example electrified lines or aerial contact lines 20 of a power supply line 2, which may be above the roof 1 a of the train 1.

The aerial contact line 20 is, for example, supported by supporting poles 22.

According to one or more embodiments not illustrated, the electrified line 20 of the power supply line 2 may be below the train 1, for example between the tracks, the so-called third rail. In this case, the sliding contact 10 is also on a lower portion of the train 1.

Electric traction vehicles 1, for example trains, may be configured to travel along a transport line, for example a railway line. The transport lines may form part of a network, for example a railway network, and each of the railway lines may comprise one or more power supply lines 2 which may allow the transit of the vehicles 1 from one point to another of the network, for example from one railway station to another.

Devices for detecting electric arcs according to this invention are illustrated, with corresponding blocks labelled 3, in Figure 1.

Any device 3 may be configured to detect the arcs or electric discharges which occur substantially at the above-mentioned contact portions 4, between the sliding contact 10 of the train 1 and the electrified line 20 of the supply line 2. The arcs are created, for example, if the sliding contact 10 loses adherence relative to the electrified line 20 creating a distance with it.

Figure 2 illustrates an example of a device 3 for detecting electric arcs which occur between a sliding contact 10 of the electric traction vehicle 1 and the respective power supply line 2. The device 3 comprises at least one radiofrequency receiving circuit (RF) 30 configured, when operating, to receive/detect a first radiofrequency signal IN1. The first signal IN1 received comprises one or more components indicating an intensity, a frequency and an electromagnetic spectrum of one or more electric arcs. For this reason, the detection device 3 may be configured to detect the presence and/or the formation of one or more electric arcs which occur between the electrified line 20 and the sliding contact 10 of the train 1.

According to one embodiment, as shown by way of example in Figure 2, the receiving circuit 30 may be coupled to a processor 32. The processor 32 may be inside the device 3, as shown in Figure 2, or outside it. In this first case, as illustrated in Figure 1, all the components of the device 3 - including the processor 32 - may be mounted at the contact portions 4.

According to one or more embodiments, the processor 32 may be configured to receive the first signal IN1 and check if an electric arc is present in the contact portion 4.

According to an embodiment, the processor 32 may be configured for:
- checking a presence of at least one electric arc as a function of the first signal IN1,
- generating an output signal OUT if the presence of at least one electric arc is verified, where the second OUT signal may comprise a first component indicating the detection of the electric arc between the sliding contact 10 and the respective electrified line 20, and
- transmitting the output signal OUT.

For example, the processor 32 may verify for the presence of at least one electric arc:
- detecting whether an intensity of the first signal IN1 reaches a first predetermined threshold for a first time interval, and/or
- detecting whether one or more peaks of intensity of the first signal IN1 occur in at least a first predetermined frequency range, which may be indicative of an electric arc.

According to one or more embodiments as shown in Figure 2, the device 3 may comprise a temperature sensor 33. The temperature sensor 33 may be coupled to the processor 32 and may be configured to generate and transmit to it a second signal IN2 indicating a temperature measured at the contact portion 4. The temperature sensor 33 may be inside or outside the device 3 and may be positioned close to the contact portion 4. Preferably, the temperature sensor 33 is of the contactless type which allows the measuring of the temperature remotely.

According to one embodiment, the processor 32 may be configured to receive the second signal IN2 and to verify for the presence of an electric arc as a function of the second signal IN2, since the electric arc frees a great deal of energy (for example in the form of heat). For example, this verification may be performed by verifying if the second signal IN2 indicates that a temperature reaches (for example, exceeds) a predetermined threshold or a temperature peak is measured, for example a temperature increases suddenly for a certain time interval. The above-mentioned verification may be used in addition to a verification performed on the first signal IN1 for detecting an electric arc.

According to one embodiment, the intensity of the electromagnetic spectrum indicating an electric arc may be used for assessing a destructive potential of the electric arc.

The processor 32 may, as a function of the first signal IN1 and/or as a function of the second signal IN2, measure a quantity of energy freed to define a sort of index of the potential of degradation on the supply line 2 and on the sliding contact 10. The processor 32 may be configured to calculate an index of the potential of degradation of the electrified line 20 and/or the sliding contact 10 of the electric traction vehicle 1 at the electrical contact portion 4 as a function of the second signal IN2 and/or as a function of an intensity of the first signal IN1. For example, the index of the potential of degradation may contain an indication of a probability that a certain component (for example, parts of the contact line or of the pantograph) is damaged or deteriorated.

Moreover, the processor 32 can generate the output signal OUT comprising a component indicating the index of the potential of degradation.

According to one or more embodiments, the device 3 may comprise a respective energy source, for example a rechargeable battery B as illustrated in Figure 2, since the device 3 may comprise low energy components. The battery B may be configured to supply energy to the various components of the device 3. Preferably, the battery B may be configured to supply energy to the components of the device 3 mounted at the contact portion 4. The presence of the battery B may allow the device 3 to be independent of external energy sources, such as, for example, the motor unit of the train 1 or the electrified lines 20.

Moreover, the battery B may be coupled to the processor 32, and the processor 32 may be configured to verify a status of the power supply source B, for example if the battery is discharged or almost discharged.

According to one or more embodiments, the battery B may be removed from the device and replaced, and/or the battery B may be rechargeable.

For example, the battery B may be coupled to a harvester energy module 34, which may be inside the detection device 3. The harvester energy module 34 may be configured for recharging the battery B through recovery energy. For example, examples of harvester energy 34 may comprise coils for recovering electromagnetic energy, solar cells and/or small wind turbines.

According to an embodiment, the device 3 may comprise a localisation module 36, for example a GPS localisation module, positioned close to the electrical contact portion 4 between the sliding contact 10 of the electric traction vehicle 1 and the respective electrified line 20. The localisation module 36 may be configured for generating and transmitting a third signal IN3 to the processor 32, wherein the third signal IN3 indicates a position of the device 3 as well as a position of the contact portion 4 at which an electric arc may occur relative to the respective electrified line 20. By associating a detection of the electric arc to a respective position, it is possible to associate a detection of the electric arc to a predetermined portion of a predetermined supply line 2 for powering the respective railway line inside the railway network, for example if the device 3 is mounted on a train 1 which, in use, moves along the railway line.

According to an embodiment, the processor may be configured to receive the third signal IN3 and to generate a third component of the output signal OUT indicating the position of the localisation module 36 as well as the electric arc measured relative to the supply line 2 along which the electric traction vehicle 1 moves.

According to one embodiment as illustrated in Figure 2, the device 3 may comprise a transmission circuit 38, for example a radio frequency circuit, coupled to the processor 32 and configured for transmitting the output signal OUT. The output signal OUT may be transmitted to the train 1 and/or to a remote processing unit, not illustrated in Figure 2. As mentioned above, the OUT output signal may comprise one or more signal components indicating, for example, the status of the battery B and/or the presence of an electric arc at the contact portion 4 between the electrified line 20 and the sliding contact 10.

According to an embodiment, the radio frequency receiver 30 and transmission 38 circuits may comprise a single receiving/transmission circuit, for example a radio frequency transceiver.

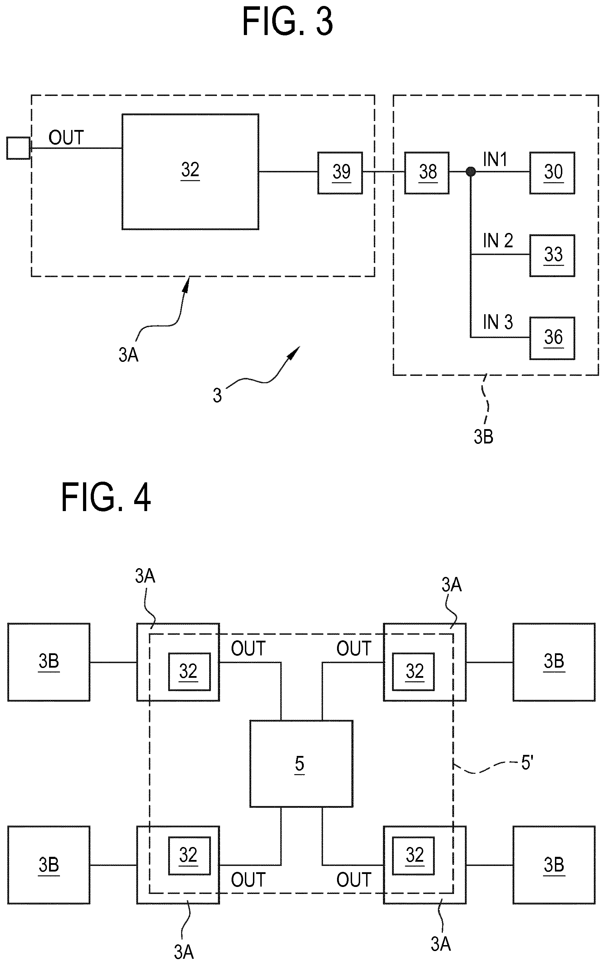

According to one or more embodiments, as illustrated in Figure 3, the device may be divided into two portions, a first portion 3A comprising the processor 32 and at least one further receiving circuit 39, for example a radio frequency circuit, and a second portion 3B comprising at least the radio frequency receiving circuit 30 designed for detecting the electric arc and the transmission circuit 38, for example a radio frequency circuit (if necessary in the form of a single receiving/transmission circuit). As shown in Figure 3, according to one or more embodiments, the second portion 3B of the device 3 may also comprise the temperature sensor 33 and/or the localisation module 36.

For example, the first portion 3A of the device 3 may be positioned inside the train 1 or it may be part of an IT product, which can be loaded in the memory of one or more processors (for example, a computer which is in the train 1 or in the information technology cloud, which allows the data storage, processing and transmission through an Internet network by means of resources assigned to a user) and comprising portions of software code to perform the steps for which the processor 32 is configured with reference to any one of the embodiments described above.

Moreover, the second portion 3B of the device 3 may be positioned at the electrical contact portion 4 between the sliding contact 10 and the electrified line 20.

According to one or more embodiments, the power supply source B and/or the harvester energy module 34, not shown in Figure 3, may be configured for powering the components of the device 3 in the portion 3B and can therefore be positioned at the electrical contact 4.

According to one embodiment as shown by way of example in Figure 3, the portions 3A and 3B of the device 3 may be coupled by means of the transmission circuit 38 and the further receiving circuit 39. For example, the transmission circuit 38 may be configured for receiving the first, second and third signal IN1, IN2, IN3 and for transmitting it to the further receiving circuit 39. The further receiving circuit 39, coupled to the processor 32, may be configured to receive the first, second and third signal IN1, IN2, IN3 and to transmit it to the processor 32.

In turn, after processing the signals, the processor 32 may generate the OUT output signal. According to one or more embodiments, the processor 32 may store the output signal OUT and/or may transmit it to a remote processor, for example in a wired manner or by means of a further transmission circuit, not visible in Figure 3. Again, the further transmission circuit and the further receiving circuit 39 may comprise a single transceiver circuit.

According to one or more embodiments, a plurality of devices 3 (possibly divided into the first portion 3A and into the second portion 3B) may transmit the OUT output signals to a remote processor 5, as illustrated in Figure 4. For example, the remote processor 5 can receive - at intervals - one or more output signals OUT from the devices 3 as a result of a detection by the devices 3 of at least one electric arc.

The remote processor 5 may be configured for:
- receiving the plurality of OUT output signals transmitted by one or more devices 3, and
- verifying, as a function of the plurality of output signals OUT, a presence of one or more critical conditions at one or more electrified lines 20 of railway lines of the network and/or at one or more sliding contacts 10 of electric traction vehicles 1 which transit along the railway lines of the network.

For example, the remote processor 5 may verify a presence of one or more critical conditions at a particular sliding contact 10 as a function of a number of times in which the device 3 at that particular sliding contact 10 transmits an output signal OUT. In fact, considering a device 3 (or the portion 3B of it) mounted at the sliding contact 10 on the vehicle 1, it is possible to assess whether the sliding contact 10 has a degradation and/or a malfunction by calculating a number of electric arcs and verifying whether the calculated number reaches (for example, is greater than) a certain threshold which may represent a quantity of electric arcs which during a correct operation of the sliding contact 10 occur during the transit of the vehicle 1.

Again for example, the remote processor 5 may verify a presence of one or more critical conditions at a predetermined portion of a predetermined electrified line 20 of a predetermined railway line of the network as a function of a number of times in which an electric arc is detected at the predetermined portion of the predetermined electrified line 20, if a position of the electric arc is known relative to the plurality of electrified lines 20. In fact, considering a predetermined portion of the railway line, it is possible to consider the devices 3 (or the portions 3B of them) which transit in that predetermined portion and/or the devices 3 (or the portions 3B of them) which are mounted on the supporting poles 22 of that portion. If several devices 3 detect the presence of an electric arc at that predetermined portion of railway line and the number of these detections exceeds a certain critical threshold, a critical condition detected in that predetermined portion of line may be declared.

According to one or more embodiments, the position of the electric arcs detected may be the result of a localisation module 36 of the type previously discussed. Alternatively, it is possible to use a module for locating the train 1, for example a GPS localisation device mounted on the train 1 or a dynamic map of the trains in transit, for detecting the position. Moreover, the devices 3 mounted on the supporting poles 22 may comprise predetermined information on their position, since they are static. According to one or more embodiments, as shown by way of example in Figure 4, the processors 32 of the plurality of devices 3 and the remote processor 5 may be included in a single processor 5'. The processor 5' may comprise an IT product, which can be loaded on the memory of at least one processor (for example, different portions of the IT product can be loaded on the cloud or on a plurality of computers on board respective electric traction vehicles 1, connected to each other by a communication network, for example the Internet) and containing portions of software code to perform the steps for which the processors 32 and the remote processor 5 are configured with reference to any one of the embodiments previously specified.

In this case, the portions 3B of the devices 3 can transmit respective first, second and third signals IN1, IN2, IN3 to a further receiving circuit 39 (not visible in the drawing) coupled to the processor 5'.

According to one or more embodiments, as shown in Figure 1, one or more devices 3 and/or the portions 3B of the devices 3 may be mounted at sliding contacts 10, for example on the roofs 1a, of a plurality of electric traction vehicles 1 and/or at a plurality of supporting poles 22. For example, a plurality of devices 3 or portions 3B of the plurality of devices 3 may be located along a plurality of power supply lines 2 of respective railway lines of a larger railway network to allow a diagnosis/maintenance, for example during the transit of the trains 1.

In fact, if a position of the train 1 is known, for example by means of a localisation module 36, when an electric arc is formed it is possible to identify one or more critical points of the line, for example points in which the presence of one or more electric arcs is likely to damage the mechanical/electrical components of the system.

Similarly, the detection of a large number of electric arcs, for example independent of the position of the train 1 relative to the power supply line 2, by a predetermined device 3 mounted on the roof 1a of the train 1 may indicate a degradation of the sliding contact 10 of the train 1. In effect, if the sliding contact 10 has malfunctions, a plurality of electric arcs can form along the entire path of the train 1 and the electric arcs, in this case, could be solely linked to the sliding contact 10. For example, it is possible to detect a presence of a critical condition for a sliding contact 10 of the train 1 if a certain device 3 mounted at the sliding contact 10 detects a number of electric arcs which reaches (for example, exceeds) a certain threshold.

In addition or alternatively, as shown by way of example in Figure 1, the detection devices 3 may be mounted on the poles 22 of the plurality of supporting poles 22, preferably close to the electrified lines 20. In other words, the devices 3 may be positioned along the entire height of the supporting poles 22. In the same way as described above, the presence of detection devices 3, fixed on the supporting poles 22 at predetermined points of the transport network (railway), may be used for diagnostics on the power supply lines 2. Preferably, a greater density of the devices 3 may be provided in portions of the transport network which may have one or more critical aspects, for example the inside of a tunnel or portions subject to modifications to the ballast. In this way, all the trains 1 which pass along the power supply lines 2 having devices 3 along them can be assessed, irrespective of the presence of the device 3 on board the trains.

According to one or more embodiments, wherein, for example, the electrical contact portion is lower than the train (that is, if there is a third rail as a power supply line 2), it is possible to position one or more devices 3 at the ballast.

According to one or more embodiments, the devices 3 may be mechanically anchored at the sliding contacts 10 (for example on the roof 1a) of the train 1 and/or on the poles 22 supporting the power supply line 2. Moreover, the devices 3 or the portions 3B of the devices 3 may comprise a relative energy source, so that the device 3 is electrically independent from the train 1 and/or from the electrified line 20. In this way, the installation of the device 3 may be simple and solely mechanical.

In other words, the devices 3 may form part of a diagnosis network of a plurality of electrified lines 20 and/or sliding contacts 10 of a plurality of electric traction vehicles 1, each sliding contact 10 of each electric traction vehicle 1 being connectable to a respective electrified line 20 in the plurality of electrified lines 2 for powering the respective electric traction vehicle 1. The diagnosis network may therefore comprise a plurality of devices 3 for detecting electric arcs according to one or more embodiments and a remote processor 5, 5', configured for:
- receiving a plurality of OUT output signals from at least one device 3 in the plurality of devices indicating electric arc detection which occur at the contact portions 4, and
- verifying, as a function of the plurality of output signals OUT, a presence of one or more critical conditions at least at one electrified line 20 in the plurality of electrified lines 20 and/or at least at one sliding contact 10 of an electric traction vehicle 1 in the plurality of electric traction vehicles 1.

According to one or more embodiments, the remote processor 5; 5' may:
- verify a presence of one or more critical conditions at a predetermined sliding contact (10) calculating the number of times in which a device in the plurality of devices mounted at the predetermined sliding contact (10) transmits an output signal (OUT), and/or
- verifying a presence of one or more critical conditions at a predetermined portion of a predetermined electrified line 20 calculating the number of times in which an electric arc is detected at the predetermined portion of the predetermined electrified line 20, if a position of the electric arc is known relative to the plurality of electrified lines 20.

According to one or more embodiments, a device 3 or a portion 3B of the device 3 in the plurality of devices is positioned:
- at the sliding contact 10 of an electric traction vehicle 1 in the plurality of electrical traction vehicles 1, and/or
- at a supporting pole 22 in the plurality of supporting poles 22 of an electrified line 20 in the plurality of power supply lines.

An advantage of this diagnostic network may comprise the fact that the data relating to a detection of the formation of the electric arc and its intensity, preferably together with a geolocation of the phenomenon and/or electrical measurements (current, voltage, etc.), can be stored in a database and processed using *"machine learning"* operations. The processing may allow the points with the greatest critical contact issues to be easily identified.

The analysis of the data collected on the formation of electric arcs on the power supply lines, preferably geo-referenced, may therefore allow a focussed maintenance both of the power supply line 2 and of the sliding contacts 10 on board the electric traction vehicles 1. Moreover, it is possible to act at the most critical points of the power supply line, for example by reducing the speed of the vehicle 1 whilst waiting for a resetting of the line.

In the same way, an assessment of the number of arcs detected over time (for example, per second) may be used as an index to define a efficiency of the collection of current and verify at which points the power supply line 2 has greatest critical issues.

One or more embodiments may therefore refer to a method for detecting electric arcs and/or for diagnosis of a transport network, comprising the steps of:
- receiving a first radiofrequency signal IN1 from at least one receiving circuit 30 of a device for detecting electric arcs which occur between a sliding contact of an electric traction vehicle 1 and a respective electrified line 20 according to one or more embodiments,
- verifying a presence of at least one electric arc as a function of the first radiofrequency signal IN1,
- generating an output signal OUT if the presence of at least one electric arc is verified comprising a first component indicating the detection of the electric arc between the sliding contact 10 of the electric traction vehicle 1 and the respective electrified line 20, and
- transmitting the output signal OUT.

According to one or more embodiments, verifying the presence of at least one electric arc as a function of the first radiofrequency signal IN1 may comprise:
- detecting whether an intensity of the first radiofrequency signal IN1 reaches (for example, exceeds) a first predetermined threshold for a first time interval, and/or
- detecting whether one or more peaks of the first radiofrequency signal IN1 occur in at least a first predetermined frequency range.

According to one or more embodiments, the method may comprise:
- calculating, as a function of an intensity of the first radiofrequency signal (IN1), an index of the potential of degradation of the electrified line (20) and/or the sliding contact (10) of the electric traction vehicle (1), and
- generating a second component of the output signal OUT indicating the index of the calculated potential of degradation.

According to one or more embodiments, the method may comprise:
- receiving a second signal IN2 indicating a temperature measured at the electrical contact portion 4, and
- verifying a presence of at least one electric arc as a function of the second signal IN2, preferably verifying if the temperature measured at the electrical contact portion 4 reaches (for example, exceeds) a second predetermined threshold.

According to one or more embodiments, the method may comprise:
- receiving a second signal IN2 indicating a temperature measured at the electrical contact portion 4, and
- calculating an index of the potential of degradation of the electrified line 20 and/or the sliding contact 10 of the electric traction vehicle 1 at the electrical contact portion 4 as a function the second signal IN2 and/or as a function of an intensity of the first radiofrequency signal IN1.

According to one or more embodiments, the method may comprise:
- receiving a third signal IN3 indicating a position of the electrical contact portion 4 with respect to the electrified line 20, and
- generating a third component of the output signal OUT indicating the position relative to the electrified line 20 of the at least one electric arc detected between the sliding contact 10 of the electric traction vehicle and the respective electrified line 20.

According to one or more embodiments, the method may comprise:
- receiving a plurality of output signals (OUT), indicating the detection of electric arcs which occur at electrical contact portions (4) between sliding contacts (10) of a plurality of electric traction vehicles (1) and respective electrified lines (20) in a plurality of electrified lines (20), and
- verifying, as a function of the plurality of output signals OUT, a presence of one or more critical conditions at least at one electrified line 20 in the plurality of electrified lines 20 and/or at least at one sliding contact 10 of an electric traction vehicle (1) in the plurality of electric traction vehicles 1.

According to one or more embodiments, verifying a presence of one or more critical conditions may comprise:
- calculating a number of times in which an OUT output signal of the plurality of OUT output signals is transmitted by a certain device of the plurality of devices, and/or
- calculating a number of times in which an electric arc is detected at a certain position relative to an electrified line 20 in the plurality of electrified lines, if a position of the electric arc is known relative to the plurality of electrified lines 20.

One or more embodiments refer to a diagnosis network of electrified lines and/or sliding contacts of electric traction vehicles 1. The diagnosis network may be configured to detect deterioration inside a network of electrified lines in which electric traction vehicles circulate. The diagnosis network may be configured to detect deterioration at the sliding contacts of the electric traction vehicles which pass through the network of electrified lines.

In this way, it is possible to recognise critical conditions at an electric vehicle and/or at precise zones of the network of electrified lines which, if left uncontrolled, can lead to faults in the network.

The diagnosis network may be configured to transmit the data indicating the critical conditions detected in such a way that an operator is able to intervene on the electrified lines and/or on the sliding contacts of the electric vehicles before damage and service interruptions occur in the network.

The remote processor of the diagnosis network may receive a plurality of data indicating the status of the network of electrified lines and/or the sliding contacts of the electric traction vehicles. For example, in addition to detecting the formation of electric arcs using the electrical arc detection devices, the diagnosis network may comprise a plurality of sensors which transmit one or more of the following data to the remote processor:
- atmospheric conditions (humidity, temperature, rain, snow, ice, wind, etc.),
- speed of electric traction vehicles,
- -type of electric traction vehicle,
- type of sliding contact,
- it is the electric traction vehicle along the network of electrified lines, and/or
- geographical position, for example the zone of the electric line affected by the formation of the electric arc and/or the electric traction vehicle which travels along a predetermined path in the network of electrical lines.

The sensors may be positioned, for example, at the sliding contacts of the electric traction vehicles and/or poles supporting electrified lines and/or inside electric traction vehicles (for example, sensors integrated inside the vehicle).

According to one or more embodiments, through the data received and through machine learning operations, the remote processor may be configured to perform at least one of the following actions:
- generating a schematic analysis on the transport network (railway), for example by analysing the system including the electrified lines of the transport network and the sliding contacts of the electric traction vehicles,
- identifying possible critical points, also indicating their precise position inside the transport network, and/or
- generating statistics on the quality of materials, suppliers and brands used for the electrified contact lines and for the sliding contacts.

On the basis of the processing operations listed, performed by the remote processor, it is possible to perform preventive maintenance of the transport network, which make it possible to reduce or eliminate accidents, service limitations, blockage of the traffic with consequent adverse economic affects (ticket refund requests, repair and stoppage costs, image damage, etc.)

In order to identify possible critical points, the remote processor may perform one or more of the following actions:
- calculating a number of times in which an electric arc is detected at a predetermined sliding contact and/or a predetermined portion of electric line, and/or
- monitoring, in addition to the number, an intensity of the electric arcs measured at a predetermined sliding contact and/or a predetermined portion of the electric line, and/or
- monitoring a duration of the life of the components of the transport network, for example of the sliding contacts and/or of the electrical lines, and/or
- verifying if the data received from the plurality of sensors is within acceptable predetermined ranges.

Thanks to this data, the remote processor may be configured for calculating an index of the potential of degradation of predetermined portions of the electrified line and/or the sliding contacts, with the index of the potential of degradation which indicates a probability of predetermined portions of the electrified line and/or the sliding contacts of being degraded and/or faulty.

For example, the index of the potential of degradation may comprise a value between a lower end (for example 0) and an upper end (for example 1), respectively indicating the absence of deterioration and the presence of a fault.

The index of the potential of degradation may vary, for example, as a function of the life of the component considered and/or of the number and intensity of electric arcs verified.

On the basis of the index of potential degradation, it is possible to carry out focussed maintenance, for example a maintenance which gives preference to the portions of the electrified lines and/or the sliding contacts of the electric vehicles which have a potential degradation index towards the upper end, therefore having a greater probability of failure.

## Claims

1. A diagnosis network of a plurality of electrified lines (20) and/or of sliding contacts (10) of a plurality of electric traction vehicles (1), each sliding contact (10) of each electric traction vehicle (1) being connectable to a respective electrified line (20) in the plurality of electrified lines (20) for powering the respective electric traction vehicle (1), the diagnosis network comprising:
- - a plurality of devices for detecting electric arcs which occur between a sliding contact (10) of an electric traction vehicle (1) and a respective electrified line (20), the sliding contact (10) being connectable to the electrified line (20) for powering the electric traction vehicle (1), each device comprising:
- at least one radiofrequency receiving circuit (30), configured to receive a first radiofrequency signal (IN1), the at least one radiofrequency receiving circuit (30) being positioned in proximity to an electrical contact portion (4) between the sliding contact (10) of the electric traction vehicle (1) and the respective electrified line (20),
- a processor (32), configured for:
- receiving the first radiofrequency signal (IN1) from the at least one receiving circuit (30),
- verifying a presence of at least one electric arc as a function of the first radiofrequency signal (IN1),
- generating an output signal (OUT) if the presence of at least one electric arc is verified, the output signal (OUT) comprising a first component indicating the detection of the electric arc between the sliding contact (10) of the electric traction vehicle (1) and the respective electrified line (20), and
- transmitting the output signal (OUT);
- a remote processor (5; 5'), configured for:
- receiving a plurality of output signals (OUT) from at least one device in the plurality of devices, the output signals (OUT) indicating the detection of electric arcs which occur at the contact portions (4), and
- verifying, as a function of the plurality of output signals (OUT), a presence of one or more critical conditions at least at one electrified line (20) in the plurality of electrified lines (20) and/or at least at one sliding contact (10) of an electric traction vehicle (1) in the plurality of electric traction vehicles (1).

2. The diagnosis network according to claim 1, wherein the processor (32) is configured for verifying the presence of at least one electric arc as a function of the first radiofrequency signal (IN1):
- detecting whether an intensity of the first radiofrequency signal (IN1) reaches a first predetermined threshold for a first time interval, and/or
- detecting whether one or more peaks of the first radiofrequency signal (IN1) occur in at least a first predetermined frequency interval.

3. The diagnosis network according to claim 1 or 2, wherein the processor (32) is configured for:
- calculating an index of the potential of degradation of the electrified line (20) and/or the sliding contact (10) of the electric traction vehicle (1) at the electrical contact portion (4) as a function of an intensity of the first radiofrequency signal (IN1), the index of the potential of degradation being indicative of a probability that a certain component of the diagnosis network is damaged or deteriorated, and
- generating a second component of the output signal (OUT) indicating the calculated index of the potential of degradation.

4. The diagnosis network according to any one of claims 1 to 3, wherein each detection device comprises a temperature sensor (33) positioned in proximity to the electrical contact portion (4) between the sliding contact (10) of the electric traction vehicle (1) and the respective electrified line (20) and configured to generate a second signal (IN2) indicating a temperature measured at the electrical contact portion (4),
wherein the processor (32) is configured to receive the second signal (IN2) and to verify a presence of at least one electric arc as a function of the second signal (IN2), preferably verifying whether the temperature measured at the electrical contact portion (4) reaches a second predetermined threshold.

5. The diagnosis network according to any one of the preceding claims, wherein each detection device comprises a temperature sensor (33) positioned in proximity to the electrical contact portion (4) between the sliding contact (10) of the electric traction vehicle (1) and the respective electrified line (20) and configured to generate a second signal (IN2) indicating a temperature at the electrical contact portion (4),
wherein the processor (32) is configured to receive the second signal (IN2) and to calculate an index of the potential of degradation of the electrified line (20) and/or the sliding contact (10) of the electric traction vehicle (1) at the electrical contact portion (4) as a function of the second signal (IN2) and/or as a function of an intensity of the first radiofrequency signal (IN1), the index of the potential of degradation being indicative of a probability that a certain component of the diagnosis network is damaged or deteriorated.

6. The diagnosis network according to any one of the preceding claims, wherein each detection device comprises a localisation module (36), preferably positioned in proximity to the electric contact portion (4) between the sliding contact (10) of the electric traction vehicle (1) and the respective electrified line (20) and configured to generate a third signal (IN3) indicating a position of the electrical contact portion (4) relative to the electrified line (20),
wherein the processor (32) is configured to receive the third signal (IN3) and to generate a third component of the output signal (OUT) indicating the position relative to the electrified line (20) of the at least one electric arc detected between the sliding contact (10) of the electric traction vehicle and the respective electrified line (20).

7. The diagnosis network according to any one of the preceding claims, wherein each detection device comprises a rechargeable power source (B), the device preferably comprising an energy harvester module (34) configured for recharging the power supply source (B) through recovery energy.

8. The diagnosis network according to any of the previous claims, wherein the remote processor (5; 5') may:
- verify a presence of one or more critical conditions at a predetermined sliding contact (10) calculating the number of times in which a device in the plurality of devices mounted at the predetermined sliding contact (10) transmits an output signal (OUT), and/or
- verify a presence of one or more critical conditions at a predetermined portion of a predetermined electrified line (20) calculating the number of times in which an electric arc is detected at the predetermined portion of the predetermined electrified line (20), if a position of the electric arc is known with respect to the plurality of electrified lines (20).

9. The diagnosis network according to any of the preceding claims, wherein at least one radiofrequency receiving circuit (30) of a device in the plurality of devices is positioned:
- at the sliding contact (10) of an electric traction vehicle (1) in the plurality of electrical traction vehicles (1), and/or
- at a supporting pole (22) in a plurality di supporting poles (22) of an electrified line (20) in the plurality of electrified lines (20).

10. A method for a diagnosis of a plurality of electrified lines (20) and/or of sliding contacts (10) of a plurality of electric traction vehicles (1), comprising the steps of:
- providing a diagnosis network according to any of the preceding claims comprising a plurality of detection devices and a remote processor (5; 5'),
- receiving a first radiofrequency signal (IN1) from the receiving circuit (30) of at least one device for detecting electric arcs,
- verifying a presence of at least one electric arc as a function of the received first radiofrequency signal (IN1),
- generating an output signal (OUT) if the presence of at least one electric arc is verified, the output signal (OUT) comprising a first component indicating the detection of the electric arc between the sliding contact (10) of the electric traction vehicle (1) and the respective electrified line (20), and
- transmitting the output signal (OUT)
- receiving, at the remote processor (5; 5'), a plurality of output signals (OUT), indicating the detection of electric arcs which occur at electrical contact portions (4) between sliding contacts (10) of a plurality of electric traction vehicles (1) and respective electrified lines (20) in a plurality of electrified lines (20), and
- verifying, as a function of the plurality of output signals (OUT), a presence of one or more critical conditions at least at one electrified line (20) in the plurality of electrified lines (20) and/or at least at one sliding contact (10) of an electric traction vehicle (1) in the plurality of electric traction vehicles (1).

11. The method according to claim 10, comprising the steps of:
- calculating, as a function of an intensity of the first radiofrequency signal (IN1), an index of the potential of degradation of the electrified line (20) and/or the sliding contact (10) of the electric traction vehicle (1), the index of the potential of degradation being indicative of a probability that a certain component of the diagnosis network is damaged or deteriorated, and
- generating a second component of the output signal (OUT) indicating the calculated index of the potential of degradation.

12. The method according to claim 10 or 11, comprising the steps of:
- receiving a second signal (IN2) indicating a temperature measured at the electrical contact portion (4), and
- verifying a presence of at least one electric arc as a function of the second signal (IN2), preferably verifying whether the temperature measured at the electrical contact portion (4) reaches a second predetermined threshold.

13. The method according to any one of claims 10 to 12, comprising the steps of:
- receiving a second signal (IN2) indicating a temperature measured at the electrical contact portion (4), and
- calculating an index of the potential of degradation of the electrified line (20) and/or the sliding contact (10) of the electric traction vehicle (1) at the electrical contact portion (4) as a function the second signal (IN2) and/or as a function of an intensity of the first radiofrequency signal (IN1), the index of the potential of degradation being indicative of a probability that a certain component of the diagnosis network is damaged or deteriorated.

14. The method according to any one of claims 10 to 13, comprising the steps of:
- receiving a third signal (IN3) indicating a position of the electrical contact portion (4) with respect to the electrified line (20), and
- generating a third component of the output signal (OUT) indicating the position relative to the electrified line (20) of the at least one electric arc detected between the sliding contact (10) of the electric traction vehicle and the respective electrified line (20).

15. The method according to any of claims 10 to 14, comprising verifying a presence of one or more critical conditions:
- calculating the number of times in which an output signal (OUT) of the plurality of output signals (OUT) is transmitted from a certain device of the plurality of devices, and/or
calculating the number of times in which an electric arc is detected at a certain position with respect to an electrified line (20) in the plurality of electrified lines (20), if a position of the electric arc is known with respect to the plurality of electrified lines (20).
